(19) Europäisches Patentamt
European Patent Office
Office européen des brevets

(11) **EP 2 629 323 A1**

(12) **EUROPEAN PATENT APPLICATION**
published in accordance with Art. 153(4) EPC

(43) Date of publication:
**21.08.2013 Bulletin 2013/34**

(51) Int Cl.:
*H01L 21/60* (2006.01)

(21) Application number: **11832392.2**

(22) Date of filing: **22.09.2011**

(86) International application number:
**PCT/JP2011/071598**

(87) International publication number:
**WO 2012/049954 (19.04.2012 Gazette 2012/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2010 JP 2010229382**

(71) Applicant: **Kabushiki Kaisha Yaskawa Denki
Kitakyushu-shi, Fukuoka 806-0004 (JP)**

(72) Inventors:
• **HONDA Tomokazu
Kitakyushu-shi
Fukuoka 806-0004 (JP)**
• **KOBAYASHI Yoshihiro
Tagawa-gun
Fukuoka 822-1296 (JP)**
• **HONDA Ryogo
Tagawa-gun
Fukuoka 822-1296 (JP)**

(74) Representative: **Viering, Jentschura & Partner
Grillparzerstrasse 14
81675 München (DE)**

(54) **ELECTRONIC DEVICE AND ELECTRONIC COMPONENT**

(57) [object] Even when a distance between electrodes of an electronic component is small, the height of a solder bump is enabled to increase.

[Solving means] An electronic device includes an IC chip 100 including a chip main body 101, a plurality of electrodes 102 formed on the chip main body 101, and a passivation 103 formed so as to include an opening at each of the electrodes 102 and cover a surface of the chip main body 101, a substrate 200 including a plurality of substrate electrodes 202 arranged facing the plurality of electrodes 102, and a plurality of solder bumps 300 configured to electrically connect the plurality of electrodes 102 with the plurality of substrate electrodes 202. A bonding area between the solder bump 300 and the electrode 102 is smaller than an opening area of the passivation 103.

[FIG. 3A]

COMPARATIVE EXAMPLE 1

[FIG. 3B]

SOLDER BUMP
(VOLUME V)

300

104

105

103

102

Δh

Lu

Lh

PRESENT EMBODIMENT

**Description**

TECHINICAL FIELD

The embodiment disclosed herein relates to an electronic device in which an electronic component such as an IC chip is mounted on a substrate by flip-chip bonding and to the electronic component.

BACKGROUND ART

Recent electronics mounting technology is drastically improved to be a key technology to realize downsizing and high performance of electronic devices. In particular, bare chip mounting, in which a bare chip is directly mounted on a printed circuit board or the like, can eliminate interposer used in a semiconductor package such as a BGA (Ball Grid Array), so that the mounting area can be largely reduced or a signal transmission distance can be shortened. Therefore, the bare chip mounting is widely used as means for realizing high density mounting.

As a bonding method of an electrode on an IC chip and an electrode of a substrate in the bare chip mounting, there are wire bonding, flip-chip bonding, and the like. The flip-chip bonding is a method in which a solder bump is formed at an electrode portion of an IC chip and the electrode is directly connected to an electrode of a substrate.

In prior art, for example, an electronic device described in Patent Document 1 is known as an electronic device in which an IC chip is mounted on a substrate by the flip-chip bonding. In this prior art, a solder bump having substantially the same height as a diameter of an electrode pad is formed by melting the solder bump on the electrode pad of the IC chip to achieve spheroidizing thereof by surface tension.

Prior Art Document

Patent Document

Patent Document 1: JP, A, 2003-152007 (Page 4, Fig. 1)

DISCLOSURE OF THE INVENTION

Problem to be solved by the Invention

The above prior art has a problem described below.

When a distance between electrodes is shortened as the size of the IC chip is reduced, a distance between solder bumps formed on the electrodes is also shortened. Therefore, the volume of the solder needs to be reduced so as not to short-circuit the electrodes adjacent to each other. On the other hand, generally, there are small undulations on a surface of a substrate due to manufacturing causes and the like, so that a certain distance needs to be ensured between the IC chip and the substrate. Therefore, the height of the solder bump formed on the electrode of the IC chip needs to be higher than a certain height. To increase the height of the solder bump, the volume of the solder needs to be increased.

Therefore, in the configuration of the prior art described above, when a small IC chip is used, the distance between the solder bumps is small, so that the volume of the solder cannot be increased, and thus it is difficult to increase the height of the solder bump.

An object of the present invention is to provide an electronic device where the height of the solder bump can be increased even when a distance between the electrodes of an electronic component is small and the electronic component.

Means for Solving the Problem

To solve the above problem, according to one aspect of the present invention, an electronic device is applied, which includes an electronic component including a chip main body, a plurality of electrodes formed on the chip main body, and a passivation formed so as to include an opening at each of the electrodes and cover a surface of the chip main body, a substrate including a plurality of substrate electrodes arranged facing the plurality of electrodes, and a plurality of solder bumps configured to electrically connect the plurality of electrodes with the plurality of substrate electrodes. A bonding area between the solder bump and the electrode is smaller than an opening area of the passivation.

According to another aspect of the present invention, an electronic component is applied, which includes a chip main body, a plurality of electrodes formed on the chip main body, a passivation formed so as to include an opening at each of the electrodes and cover a surface of the chip main body, and a plurality of UBMs which are formed on the plurality of electrodes respectively and are configured to bond the electrodes and solder bumps respectively. Each of the UBMs is formed so as to include an area smaller than an opening area of the passivation.

Advantages of the Invention

According to the present invention, it is possible to increase the height of the solder bump even when the distance between the electrodes of the electronic component is small.

BRIEF DESCRIPTION OF THE DRAWING

Fig. 1A is a schematic configuration diagram for explaining a schematic configuration of an electronic device according to an embodiment.
Fig. 1B is a schematic configuration diagram for explaining a schematic configuration of the electronic device according to the embodiment.
Fig. 1C is a schematic configuration diagram for explaining a schematic configuration of the electronic device according to the embodiment.
Fig. 2 is a vertical cross-sectional view showing a detailed structure of a bonding portion between an electrode and a solder bump.
Fig. 3A is an illustration for explaining that the height of the solder bump can be increased by the structure shown in Fig. 2.
Fig. 3B is an illustration for explaining that the height of the solder bump can be increased by the structure shown in Fig. 2.
Fig. 4 is an illustration for explaining that the durability of the solder bump can be improved by the structure shown in Fig. 2.
Fig. 5 is a flowchart showing a forming process of the solder bump.
Fig. 6A is a vertical cross-sectional view showing a forming process of UBM.
Fig. 6B is a vertical cross-sectional view showing a forming process of the UBM.
Fig. 6C is a vertical cross-sectional view showing a forming process of the UBM.
Fig. 6D is a vertical cross-sectional view showing a forming process of the UBM.
Fig. 7 is a diagram showing bump height calculation values on each shape of the formed UBM.
Fig. 8 is a diagram comparing the measured heights of the bump on each shape of the formed UBM with the calculated values.
Fig. 9 is a diagram showing a result of measuring and comparing the heights of solder bumps formed by a screen printing method and the heights of solder bumps of an example formed by a solder ball mounting method.
Fig. 10 is a table showing the heights of each solder bump that is compared.
Fig. 11 is a diagram showing a relationship between an electrode pitch and an opening length of a passivation in a range in which the example is effective.
Fig. 12 is a diagram showing a relationship between the height of the bump and the electrode pitch in a solder bump forming method.

BEST MODE FOR CARRYING OUT THE INVENTION

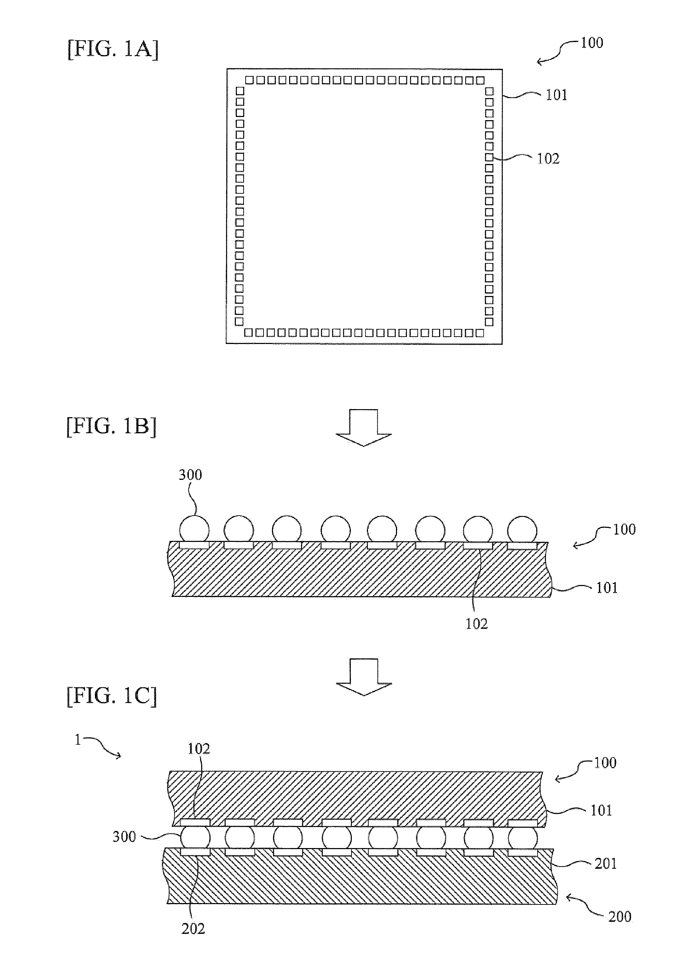

Hereinafter, an embodiment will be described with reference to the drawings.
First, a schematic configuration of an electronic device according to the embodiment will be described with reference to Figs. 1A - 1C. Figs. 1A - 1C are schematic configuration diagrams for explaining the schematic configuration of the electronic device according to the embodiment.
As shown in Fig. 1A, in an IC chip 100, which is an example of an electronic component according to the embodiment, a plurality of electrodes 102 is provided at a chip main body 101. The IC chip 100 is a so-called bare chip, which is directly mounted on a substrate 200 without being encapsulated in a package formed of plastic or ceramic.
A solder bump 300 is formed on each electrode 102 of the IC chip 100. As a forming method of a solder bump, generally, a solder ball mounting method, a screen printing method, a plating method, and the like are used. The solder ball mounting method is used in the embodiment because the solder ball has an excellent dimensional accuracy and has an advantage that the volumes of the solder are easily equalized. Therefore, a spherical solder ball is mounted on each electrode 102 and melted by a reflow process, so that a solder bump 300 is formed. As shown in Fig. 1B, the solder bump 300 is formed into a spherical shape, whose bottom surface is a bonding portion to the electrode 102, by a surface tension. As a method for mounting the solder ball on the electrode 102, a vacuum absorption method in which the solder ball is absorbed in vacuum by a jig and the solder ball is positioned on the electrode 102 to be mounted thereon, a rolling-in method in which a metal mask is used and the solder ball is rolled into an opening of the metal mask, and the like are used.

As shown in Fig. 1C, on a substrate main body 201 of a substrate 200, a plurality of substrate electrodes 202 is arranged facing the plurality of electrodes 102 of the IC chip 100. One end of the solder bump 300 is bonded to the electrode 102 of the IC chip 100 and the other end thereof is bonded to the substrate electrode 202 of the substrate 200, so that the solder bumps 300 electrically connect the plurality of electrodes 102 of the IC chip 100 and the plurality of substrate electrodes 202 of the substrate 200. In this way, the solder bumps 300 are formed on the electrodes 102 of the IC chip 100 and flip-chip bonded to the substrate electrodes 202 of the substrate 200, so that an electronic device 1 is formed.

Although here an example is described in which only one IC chip 100 is bonded to the substrate 200 to form the electronic device 1, electronic components such as other IC chips and semiconductor elements may be bonded to the substrate 200.

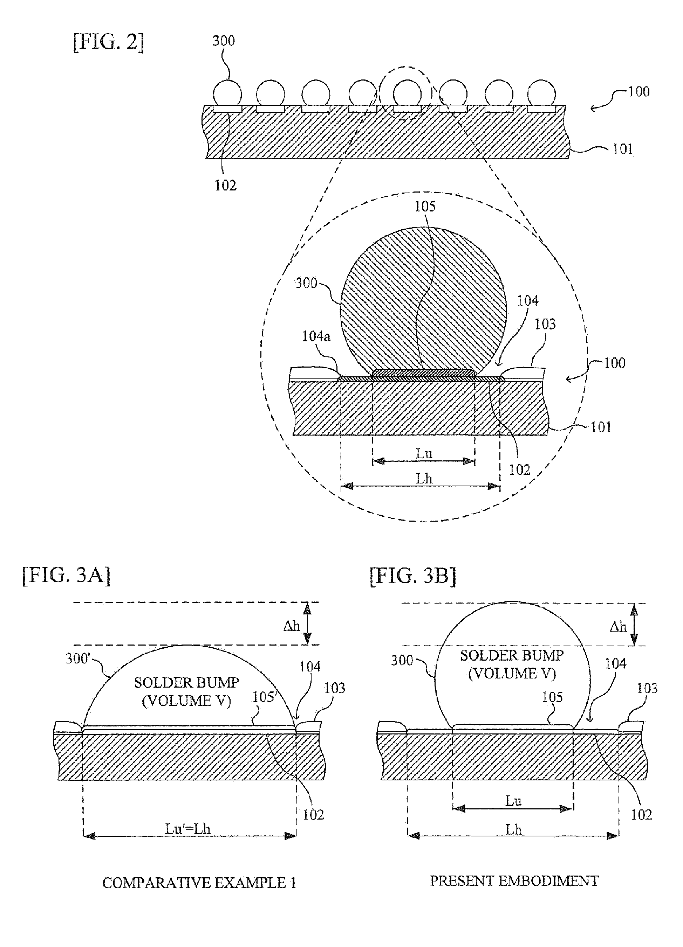

Next, a detailed structure of a bonding portion between the electrode and the solder bump will be described with reference to Fig. 2. Fig. 2 is a vertical cross-sectional view showing the detailed structure of the bonding portion between the electrode and the solder bump.

As shown in an enlarged diagram in Fig. 2, the IC chip 100 includes a chip main body 101, a plurality of electrodes 102 formed on the chip main body 101, and a passivation 103 formed so as to cover the surface of the chip main body 101. The passivation 103 has a rectangular opening at the electrode 102 and exposes the electrode 102. Hereinafter, the opening is referred to as an opening 104. The passivation 103 is formed of a resin material or a solder resist material.

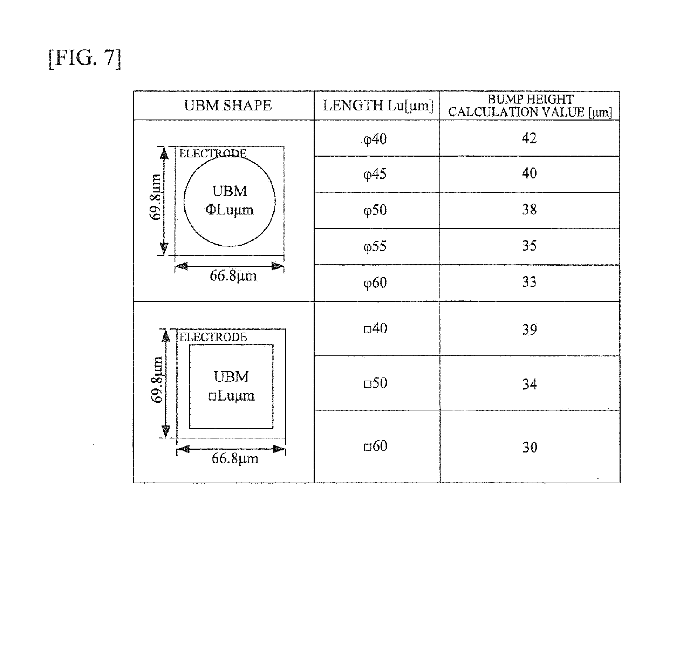

The solder bump 300 is bonded to the electrode 102 through a UBM (Under Bump Metal) 105 formed on the electrode 102. The UBM 105 is formed into a circular shape or a rectangular shape by nickel electroplating (shown in Fig. 7). Generally, the electrode 102 is formed of metal such as aluminum. However, there is a strong oxide film on the surface or the electrode 102, so that the bonding of the solder to the electrode 102 is prevented by the oxide film. Therefore, the melted solder wets only the UBM 105 and does not wet the electrode 102, so that the size and the shape of the bonding portion between the solder bump 300 and the electrode 102 are determined by the length and the shape of the UBM 105.

In the embodiment, the UBM 105 is formed on the electrode 102 so that the area of the UBM 105 is smaller than the opening area of the opening 104 of the passivation 103. Specifically, the length Lu of the UBM 105 (the diameter of the UBM 105 when the UBM 105 has a circular shape or the length of one side of the UBM 105 when the UBM 105 has a rectangular shape, and the same applies to the following) is smaller than the length Lh of one side of the opening 104. As a result, the bonding area between the solder bump 300 and the electrode 102 is smaller than the opening area of the opening 104 of the passivation 103. The UBM 105 is formed so that the entire circumference thereof is separated apart from an opening edge surface 104a of the passivation 103. As a result, the solder bump 300 is bonded to the electrode 102 so as not to be in contact with the passivation 103. As a result, the electrode 102 is exposed around the bonding portion between the solder bump 300 and the UBM 105.

Next, it will be described that the height of the solder bump 300 can be increased by the configuration shown in Fig. 2 by using a comparative example 1 with reference to Figs. 3A and 3B. Figs. 3A and 3B are each an illustration for explaining that the height of the solder bump can be increased by the structure shown in Fig. 2. Fig. 3A shows the comparative example 1 and Fig. 3B shows the configuration of the embodiment. The volumes of the solder bumps shown respectively in Figs. 3A and 3B are the same.

In the comparative example 1 shown in Fig. 3A, the length Lu' of a UBM 105' is the same as the length Lh of one side of the opening 104. In this case, when the UBM 105' has a circular shape, the UBM 105' has a shape of an inscribed circle in contact with an inner circumference of the opening 104, and when the UBM 105' has a rectangular shape, the area of the UBM 105' is substantially the same as the opening area of the passivation 103. On the other hand, in the embodiment shown in Fig. 3B, the length Lu of the UBM 105 is smaller than the length Lh of one side of the opening 104 as described above. In other words, the length Lu of the UBM 105 is smaller than the length Lu' of the UBM 105' of the comparative example 1. Therefore, the area of the bottom surface of the solder bump 300 is smaller than the area of the bottom surface of the solder bump 300' of the comparative example 1 even when the UBMs 105 and 105' have a circular shape or a rectangular shape. As a result, the height of the solder bump 300 can be higher than that of the solder bump 300' by ∆h by an effect of surface tension of the solder bump 300 without increasing the volume of the solder bump 300.

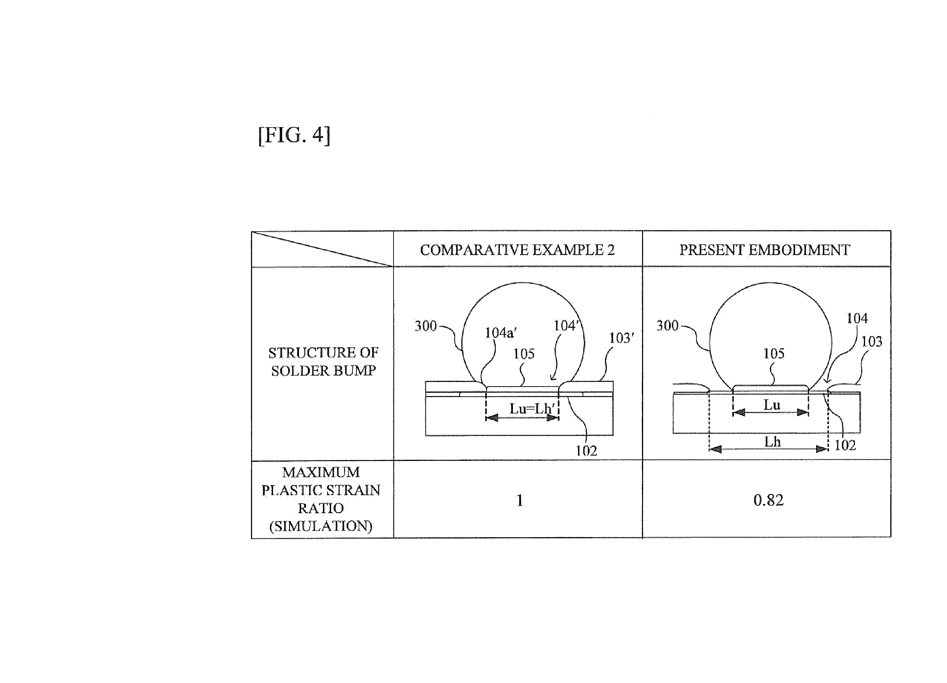

Next, it will be described that the durability of the solder bump 300 can be improved by the configuration shown in Fig. 2 by using a comparative example 2 with reference to Fig. 4. Fig. 4 is an illustration for explaining that the durability of the solder bump can be improved by the structure shown in Fig. 2.

In the comparative example 2 shown in Fig. 4, an opening 104' of a passivation 103' is formed small and the length Lh' of one side of the opening 104' is equal to the length Lu of the UBM 105. In other words, the comparative example 2 has a configuration in which the area of the bottom surface of the solder bump 300 is reduced in the same manner as in the embodiment by reducing the opening area of the opening 104' of the passivation 103' and the same height is obtained.

When the inventors of the present application simulate plastic strain in the solder when strain is applied to the solder bump in the configurations of the comparative example 2 and the embodiment, as shown in Fig. 4, it is found that, in the configuration of the embodiment, the maximum plastic strain in the solder decreases by about 20% from that of the comparative example 2. It is considered that this is because, in the comparative example 2, the passivation 103' and the solder bump 300 are in contact with each other, so that an opening edge surface 104a' of the passivation 103' cuts into the solder bump 300, and thus when strain is applied to the solder bump 300, stress concentration occurs at a portion where the passivation 103' cuts into the solder bump 300. On the other hand, the embodiment has a structure in which the solder bump 300 and the passivation 103 are not in contact with each other. As a result, the stress concentration as described above does not occur, so that the maximum plastic strain in the solder can be reduced compared with the structure of the comparative example 2. As a result, it is possible to increase the durability of the solder bump 300 and improve the reliability of the electronic device 1.

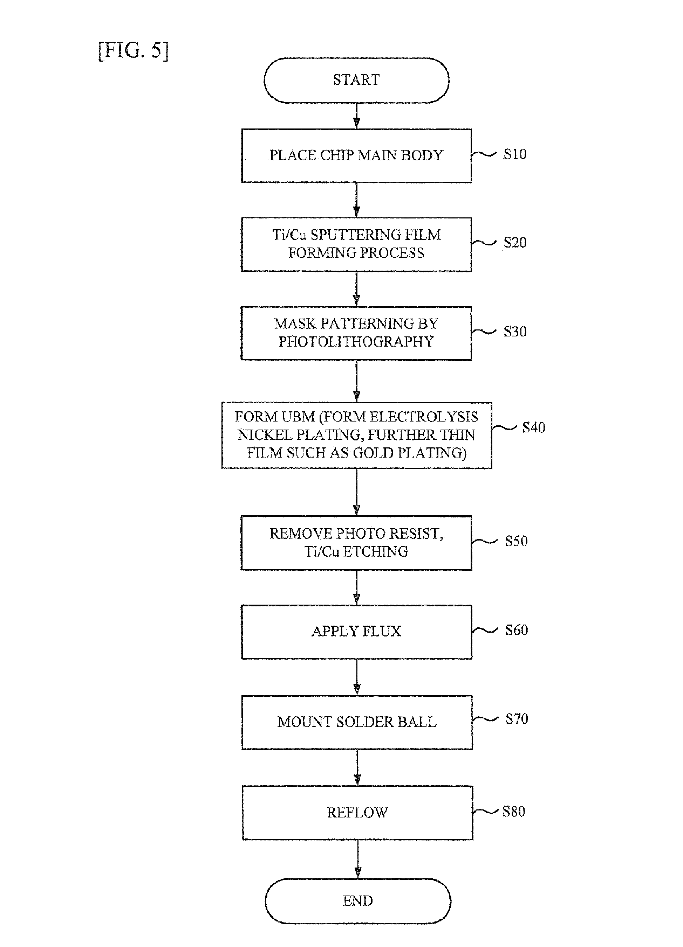

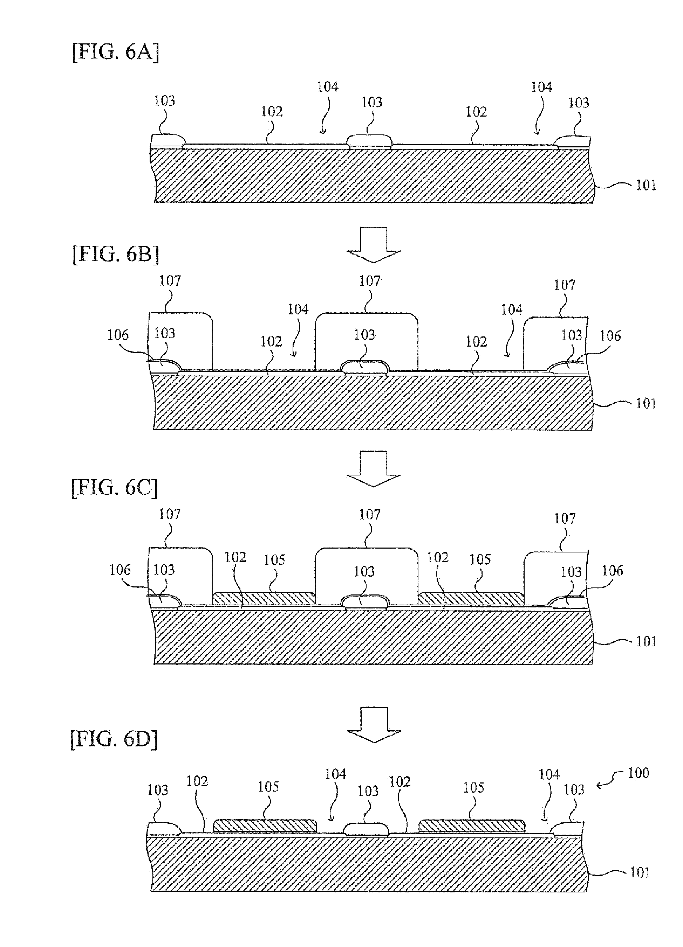

Next, a forming process of the solder bump 300 will be described with reference to Figs. 5 and 6A - 6D. Fig. 5 is a flowchart showing the forming process of the solder bump. Figs. 6A - 6D are vertical cross-sectional views showing a forming process of the UBM.

As shown in Fig. 5, first, in step S10, the chip main body 101 is placed in a film formation apparatus. As shown in Fig. 6A, the electrodes 102 and the passivation 103 are formed on the chip main body 101.

In the next step S20, a film forming process by Ti/Cu is performed. As a result, as shown in Fig. 6B, Ti/Cu is deposited on the surfaces of the electrodes 102 and the passivation 103 and a metal film 106 is formed.

In the next step S30, the chip main body 101 is taken out from the film formation apparatus described above, a photoresist is coated on the metal thin film 106 formed in step S20 described above, and mask patterning is performed by an exposure apparatus. As a result, as shown in Fig. 6B, a photoresist film 107 is formed on a part of the electrodes 102 and on the passivation 103. The photoresist film 107 is formed so as to cover a circumference of the electrode 102 so that the UBM 105 is formed smaller than the opening area of the passivation 103.

In the next step S40, the UBM 105 is formed by nickel electroplating. As a result, as shown in Fig. 6C, the UBM 105 is formed on portions other than masks of the photoresist film 107.

The nickel electroplating does not require a surface washing with an alkaline or acidic solution and the processing temperature is low, about 40°C - 50°C, so that peeling due to swelling of the photoresist film 107 is hard to occur. Therefore, for example, it is not necessary to perform a surface washing with an alkaline or acidic solution and perform a post bake process such as electroless nickel-phosphorus plating that requires a high processing temperature. When the post bake process is performed, the surface of the electrode 102 may be contaminated depending on the components of the photoresist and the contamination may be a factor that adversely affects the bonding. Therefore, the nickel electroplating can eliminate the factor that adversely affects the bonding as much as possible. In this way, it is possible to easily form the UBM 105 having a predetermined shape by the nickel electroplating. Also, it is possible to obtain good bondability to the solder bump 300.

A thin film of metal or alloy may be further formed on the surface of the UBM 105 formed by the nickel electroplating. For example, even when a thin film is formed by various plating of gold, palladium-gold, solder, rhodium, platinum, or silver, it is also possible to obtain good bondability.

In the next step S50, the photoresist film 107 formed in the above step S30 is removed and the metal thin film 106 of Ti/Cu formed in the above step S20 is etched. As a result, as shown in Fig. 6D, the photoresist film 107 and the metal thin film 106 located on portions other than the UBMs 105 are removed. In this way, the UBM 105, which has an area smaller than the opening area of the opening 104 of the passivation 103, is formed on the electrode 102, and the IC chip 100 is formed.

In the next step S60, a flux is applied. The flux has a role to improve wettability of the solder to the UBM 105. In the next step S70, a solder ball is mounted on the electrode 102 by the vacuum absorption method or the rolling-in method described above or the like. In step S80, the solder ball is melted in a heating process during reflow and the solder bump 300 is formed. As a result, the solder bump 300 is formed so that the bonding area between the solder bump 300 and the electrode 102 is smaller than the opening area of the opening 104 of the passivation 103.

Next, the embodiment will be further described in detail with reference to an example. Example

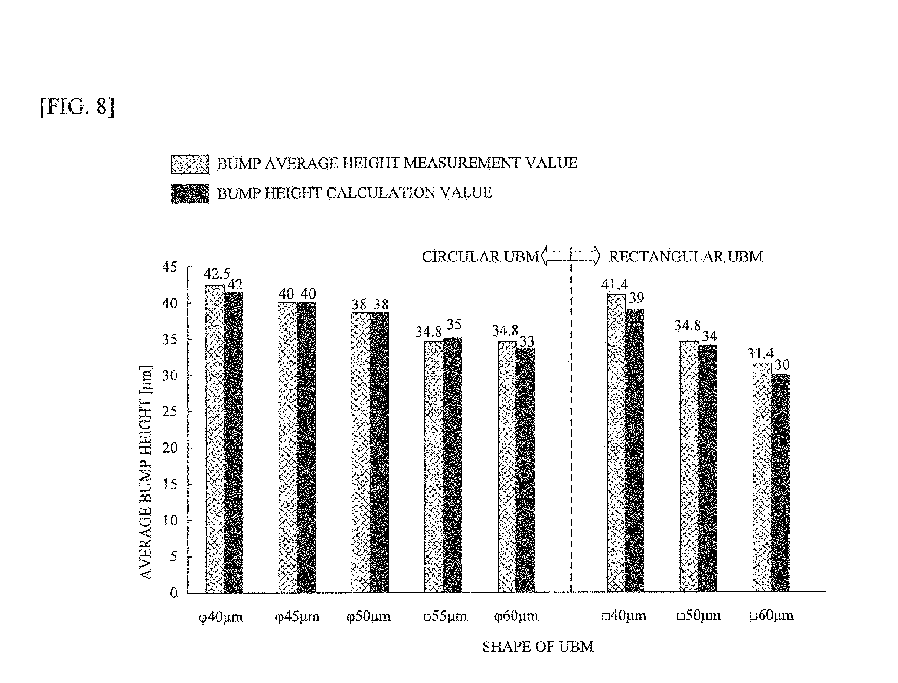

The inventors of the present application actually fabricated the solder bump 300 by the method described above and measured the height of the bump. To measure the height of the bump, eight types of shapes of UBMs 105 shown in Fig .7 are fabricated, each type being fabricated in plural number on one chip main body 101. Fig. 7 is a diagram showing calculated values of the height of the bump on each shape of the UBM. Fig. 8 is a diagram comparing the measured heights of the bump on each shape of the formed UBM with the calculated values.

As shown in Fig. 7, five types of circular UBMs having different diameters ($\Phi$ 40 $\mu$m, $\Phi$ 45 $\mu$m, $\Phi$ 50 $\mu$m, $\Phi$ 55 $\mu$m, and $\Phi$ 60 $\mu$m) are fabricated and three types of rectangular UBMs (in this example, square UBMs) having different side lengths ($\square$ 40 $\mu$m, $\square$ 50 $\mu$m, and $\square$ 60 $\mu$m) are fabricated. The height of the bump when a solder ball of $\Phi$ 50 $\mu$m is used on an UBM of each shape is calculated using Formula 1 described below which is obtained by modifying a known Goldman formula. The calculation result is shown in Fig. 7.

Formula 1

$$V_{soider} = \frac{\pi \, h_{bump}}{6}\left( h_{bump}{}^2 + 3\left(\frac{Lu}{2}\right)^2 \right)$$

$h_{bump}$: the height of the bump
Lu: the diameter or the side length of the UBM

Further, the heights of a plurality of solder bumps 300 are measured on each shape of the formed UBM. Fig. 8 shows a comparison result of average vales of the measured values (average heights of the bumps) and the calculation result shown in Fig. 7. The thickness of the formed UBMs is about 2 $\mu$m and the thickness of the passivation is about 3 $\mu$m. As shown in Fig. 8, the measured values and the calculated values of the height of the bump are substantially the same. Therefore, it is found that the calculated values of the height of the bump shown in Fig. 7 substantially correspond to the heights of the actually fabricated bumps. From the result described above, it is confirmed that, whether the UBM 105 is circular or rectangular, the smaller the length Lu is, that is, the smaller the bonding area between the solder bump 300 and the electrode 102 is, the higher the height of the bump is. Also, it is confirmed that when the UBM 105 is circular, the height of the bump can be higher than that when the UBM 105 is rectangular. Further, it is confirmed that the height of the solder bump 300 can be adjusted by changing the length Lu of the UBM 105 and can also be adjusted by the shape of the UBM 105.

As described above, the solder bump 300 having a predetermined height can be realized by forming the UBM 105 by nickel electroplating, so that the solder bump 300 can be strongly bonded to the electrode 102.

While it is found that the circular shape of the UBM 105 is advantageous to increase the height of the bump from the result described above, from the reason described below, the circular shape of the UBM is more preferable than the rectangular shape. Specifically, although the shape of the bonding portion between the solder bump 300 and the electrode 102 is substantially the same as that of the UBM 105, if the bonding portion has a polygonal shape such as a rectangular shape, when a strain is applied to the solder bump 300, there is a risk that a local stress concentration occurs inside the solder. On the other hand, when the bonding portion has a circular shape, the stress generated inside the solder can be uniform. As a result, it is possible to increase the durability of the solder bump and improve the reliability of the electronic device 1.

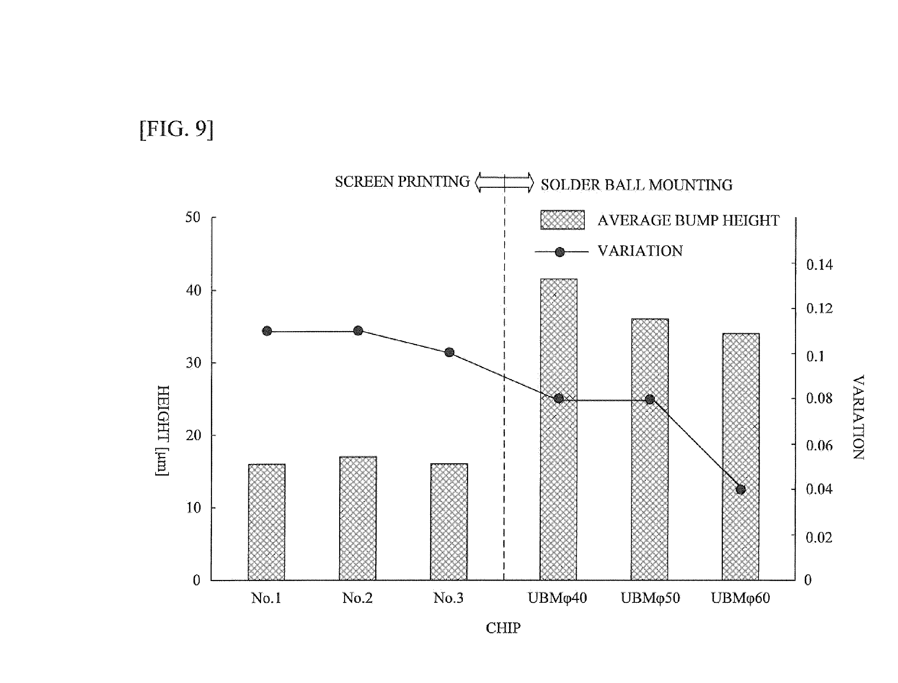

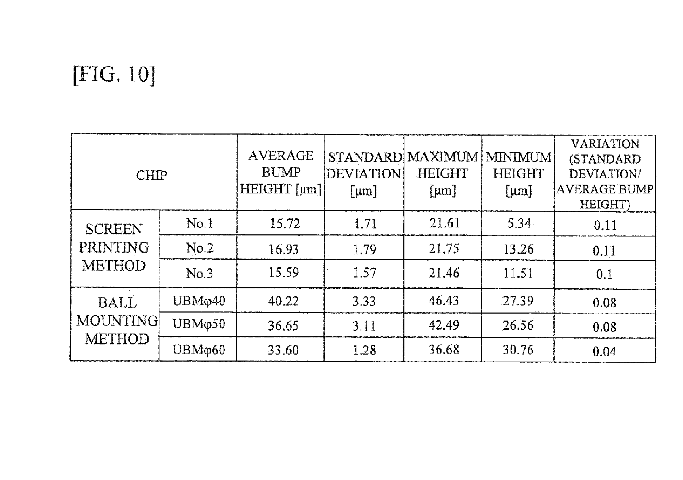

The inventors of the present application fabricated three types of solder bumps by the screen printing method as a comparative example to be compared with the solder bump fabricated in the present example and measured and compared the heights of these solder bumps and the heights of solder bumps of the present example formed by the solder ball mounting method. Figs. 9 and 10 show a comparison result thereof. Fig. 9 is a diagram showing the comparison result. Fig. 10 is a table showing the heights of the solder bumps to be compared. Differently from the present example, the solder bumps formed by the screen printing method are bonded to an electrode through a UBM having substantially the same area as the opening area of the passivation. On the other hand, the solder bumps formed by the solder ball mounting method are bonded to an electrode through a UBM which is formed to be smaller than the opening area of the passivation as described above (see $\Phi$ 40, $\Phi$ 50, $\Phi$ 60 $\mu$m in Fig. 7).

As shown in Figs. 9 and 10, it is confirmed that the heights of the solder bumps 300 formed by the solder ball mounting method in the present example are about two times higher than the heights of the solder bumps formed by the screen printing method. This is an effect of reducing the area of the UBM 105 to smaller than the opening area of the passivation 103. The variation (fluctuation) of the average height of the bumps formed by the screen printing method is about 0.1 and the variation of the average height of the solder bumps 300 of the present example formed by the solder ball mounting method is 0.08 at $\Phi$ 40 and $\Phi$ 50, so that it is confirmed that in the solder bumps 300 of the present example, the height of the bump can be higher than that of the solder bump formed by the screen printing method and the variation of the average height of the bumps can be suppressed.

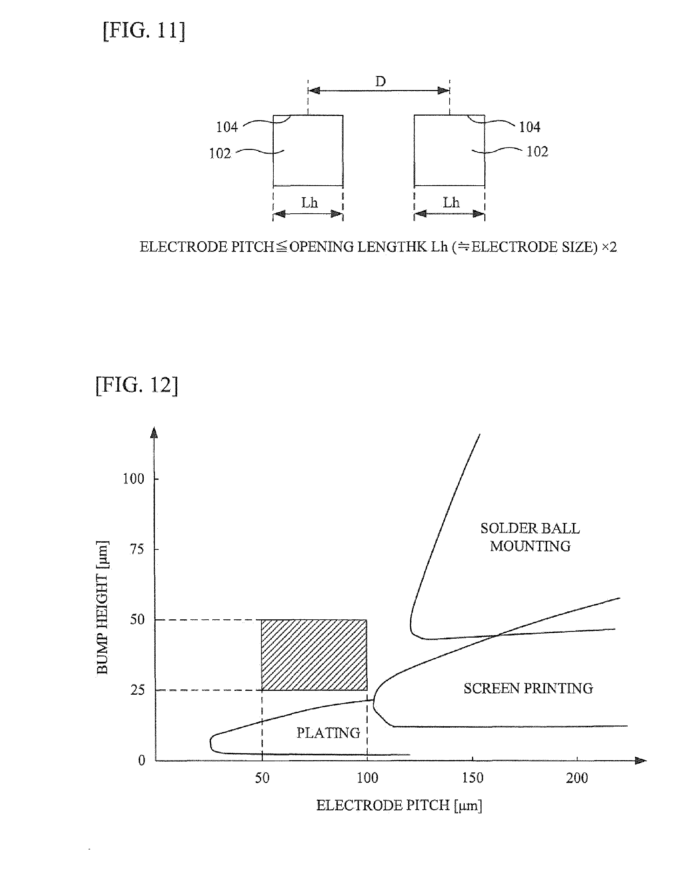

Further, the inventors of the present application fabricated the eight types of shapes of UBMs 105 shown in Fig. 7 for a plurality of types of chip main bodies 101, each of which has a different distance between the electrodes 102 (an electrode pitch), and checked whether or not the height of the bump necessary for a narrow pitch (the hatching region shown in Fig. 12) can be ensured.

As result, as shown in Fig. 11, it is confirmed that even when a narrow-pitch IC chip 100 whose electrode pitch D is equal to or smaller than two times a longest side length Lh of the opening 104 of the passivation 103 is used, the necessary height of the bump can be ensured. In particular, it is confirmed that, in a range of the electrode pitch from 50 to 100 μm, the height of the solder bump can be ensured to be about 25 to 50 um, so that it is confirmed that the present example is effective in the range. Generally, the length Lh of one side of the opening 104 of the passivation 103 substantially corresponds to the length of one side of the electrode 102, so that the above IC chip 100 can be rephrased to be a narrow-pitch IC chip 100 whose electrode pitch D is equal to or smaller than two times the length of the electrode. The shape of the opening 104 is considered to be not only rectangular but also circular and trapezoidal. When the shape of the opening 104 is circular, the longest side length is the diameter, and when the shape is trapezoidal, the longest side length is the length of the lower base.

Fig. 12 is a diagram showing a relationship between the height of the bump and the electrode pitch in solder bump forming methods of prior arts. In Fig. 12, a range in which the present example is effective in particular is indicated by the shaded area. According to the embodiment, it is possible to increase the height of the solder bump 300 even in an IC chip 100, whose electrode pitch is narrow, in a range in which the bump forming methods of prior arts cannot increase the height.

The electronic device 1 according to the embodiment described above is configured so that the bonding area between the solder bump 300 and the electrode 102 is smaller than the opening area of the passivation 103. As a result, the area of the bottom surface of the spherical solder bump 300 can be smaller than that when the bonding area between the solder bump 300 and the electrode 102 is equal to the opening area of the passivation 103, so that the height of the solder bump 300 can be increased by the effect of surface tension without increasing the volume of the solder bump 300. Therefore, it is possible to increase the height of the solder bump 300 even when the electrode pitch of the electronic component 1 is small.

The embodiment particularly has a configuration in which the solder bump 300 and the passivation 103 are not in contact with each other. As a result, the effects as described below can be exerted. Specifically, in the electronic device 1, the substrate 200 expands more than the IC chip 100 by heat generated from the IC chip 100 and a size difference occurs at the bonding portion between the IC chip 100 and the substrate 200, so that a strain occurs repeatedly in the solder bump 300, which bonds the IC chip 100 and the substrate 200 together, every time the electronic device 1 is used. Here, as a configuration to increase the height of the solder bump 300, for example, as shown by the comparative example 2 in Fig. 4, a configuration is considered in which the area of the bottom surface of the solder bump 300 is reduced by reducing the opening area of the passivation 103'. In this case, the passivation 103' and the solder bump 300 are in contact with each other, so that the opening edge surface 104a' of the passivation 103' cuts into the solder bump 300. In such a structure, when a strain is applied to the solder bump 300, a stress concentration occurs at a portion in which the passivation 103' cuts into the solder bump 300 and the maximum plastic strain in the solder increases. As a result, the durability of the solder bump 300 decreases and the reliability of the electronic device 1 deteriorates. On the other hand, in the embodiment, the solder bump 300 and the passivation 103 are not in contact with each other, so that the stress concentration as described above does not occur. Therefore, the embodiment can reduce the maximum plastic strain in the solder as compared with the configuration described above. As a result, it is possible to increase the durability of the solder bump 300 and improve the reliability of the electronic device 1.

In the embodiment, in particular, the solder bump 300 is bonded to the electrode 102 through the UBM 105 which is formed on the electrode 102 so as to have an area smaller than the opening area of the passivation 103. As a result, the bonding area between the solder bump 300 and the electrode 102 can be reliably smaller than the opening area of the passivation 103. The size of the UBM 105 is smaller than the opening area of the passivation 103, so that the electrode 102 is exposed around the UBM 105. The height of the solder bump 300 can be further increased by reducing the size of the UBM 105. Further, it is possible to adjust the height of the solder bump 300 by changing the size or the shape of the UBM 105.

In the embodiment, in particular, the solder bump 300 is bonded to the electrode 102 through the UBM 105 having a circular shape. The UBM 105 is formed into a circular shape, so that the shape of the bonding portion between the solder bump 300 and the electrode 102 can be circular. As a result, the stress generated in the solder when a strain is applied to the solder bump 300 can be more uniform than when the bonding portion is polygonal such as rectangular, so that it is possible to increase the durability of the solder bump 300 and improve the reliability of the electronic device 1.

In the embodiment, in particular, it is configured so that the bonding area between the solder bump 300 and the electrode 102 is smaller than the opening area of the passivation 103 and the UBM 105 to which the solder bump 300 is bonded is formed by the nickel electroplating. As a result, the UBM 105 having a predetermined shape can be easily formed and a good bondability between the UBM 105 and the solder bump 300 can be obtained.

In the embodiment, in particular, the IC chip 100 is configured so that the electrode pitch D of the electrode 102 is equal to or smaller than two times the length Lh of one side of the opening 104 of the passivation 103. Even when the IC chip 100 whose electrode pitch D is narrow is used in this way, the height of the solder bump 300 can be increased.

In the embodiment, in particular, the IC chip 100 is configured so that the electrode pitch D is 50 to 100 μm. Even when such a narrow-pitch IC chip 100 is used, the height of the solder bump 300 can be ensured to be high at about 25 to 50 μm.

The present disclosure is not limited to the embodiment described above, but may be taken into practice by adding various modifications without departing from the gist and the technical idea of the disclosure.

Description of Reference Numerals

1       electronic device
100     IC chip (electronic component)
101     chip main body
102     electrode
103     passivation
105     UBM
200     substrate
202     substrate electrode
300     solder bump

**Claims**

1.  An electronic device comprising:

    an electronic component including a chip main body, a plurality of electrodes formed on the chip main body, and a passivation formed so as to include an opening at each of the electrodes and cover a surface of the chip main body;
    a substrate including a plurality of substrate electrodes arranged facing the plurality of electrodes; and
    a plurality of solder bumps configured to electrically connect the plurality of electrodes with the plurality of substrate electrodes,
    a bonding area between the solder bump and the electrode being smaller than an opening area of the passivation.

2.  The electronic device according to claim 1, wherein:

    the solder bump is bonded to the electrode through an UBM which is formed on the electrode to be smaller than the opening area of the passivation.

3.  The electronic device according to claim 2, wherein:

    the solder bump is bonded to the electrode via the UBM which is formed by nickel electroplating.

4.  The electronic device according to claim 3, wherein:

    the UBM is formed on the electrode so as not to be in contact with the passivation.

5.  The electronic device according to claim 3 or 4, wherein:

    the solder bump is bonded to the electrode via the UBM comprising a circular shape.

6.  The electronic device according to any one of claims 3 to 5, wherein:

    a thin film of metal or alloy is formed on a surface of the UBM.

7.  The electronic device according to any one of claims 1 to 6, wherein:

    the electronic component is configured so that an electrode pitch of the plurality of electrodes is equal to or smaller than two times a longest side length of the opening.

8. The electronic device according to any one of claims 1 to 7, wherein:

the electronic component is configured so that the electrode pitch is 50 to 100 $\mu$m.

9. An electronic component comprising:

a chip main body;
a plurality of electrodes formed on the chip main body;
a passivation formed so as to include an opening at each of the electrodes and cover a surface of the chip main body; and
a plurality of UBMs which are formed on the plurality of electrodes respectively and are configured to bond the electrodes and solder bumps respectively,
each of the UBMs being formed so as to include an area smaller than an opening area of the passivation.

[FIG. 1A]

100

101

102

[FIG. 1B]

300

100

102

101

[FIG. 1C]

1

102

100

101

300

201

202

200

[FIG. 2]

[FIG. 3A]

COMPARATIVE EXAMPLE 1

[FIG. 3B]

PRESENT EMBODIMENT

[FIG. 4]

| | COMPARATIVE EXAMPLE 2 | PRESENT EMBODIMENT |
|---|---|---|
| STRUCTURE OF SOLDER BUMP | | |
| MAXIMUM PLASTIC STRAIN RATIO (SIMULATION) | 1 | 0.82 |

[FIG. 5]

```
           ┌─────────────────────┐
           │        START        │
           └─────────────────────┘
                      │
                      ▼
        ┌───────────────────────────┐
        │   PLACE CHIP MAIN BODY     │ ～ S10
        └───────────────────────────┘
                      │
                      ▼
        ┌───────────────────────────┐
        │   Ti/Cu SPUTTERING FILM    │ ～ S20
        │      FORMING PROCESS       │
        └───────────────────────────┘
                      │
                      ▼
        ┌───────────────────────────┐
        │    MASK PATTERNING BY      │ ～ S30
        │     PHOTOLITHOGRAPHY       │
        └───────────────────────────┘
                      │
                      ▼
    ┌─────────────────────────────────┐
    │ FORM UBM (FORM ELECTROLYSIS      │ ～ S40
    │ NICKEL PLATING, FURTHER THIN     │
    │ FILM SUCH AS GOLD PLATING)       │
    └─────────────────────────────────┘
                      │
                      ▼
        ┌───────────────────────────┐
        │   REMOVE PHOTO RESIST,     │ ～ S50
        │       Ti/Cu ETCHING        │
        └───────────────────────────┘
                      │
                      ▼
        ┌───────────────────────────┐
        │        APPLY FLUX          │ ～ S60
        └───────────────────────────┘
                      │
                      ▼
        ┌───────────────────────────┐
        │     MOUNT SOLDER BALL      │ ～ S70
        └───────────────────────────┘
                      │
                      ▼
        ┌───────────────────────────┐
        │         REFLOW             │ ～ S80
        └───────────────────────────┘
                      │
                      ▼
           ┌─────────────────────┐
           │         END         │
           └─────────────────────┘
```

[FIG. 6A]

[FIG. 6B]

[FIG. 6C]

[FIG. 6D]

[FIG. 7]

| UBM SHAPE | LENGTH Lu[μm] | BUMP HEIGHT CALCULATION VALUE [μm] |
|---|---|---|
| ELECTRODE<br>69.8μm<br>UBM<br>ΦLuμm<br>66.8μm | φ40 | 42 |
| | φ45 | 40 |
| | φ50 | 38 |
| | φ55 | 35 |
| | φ60 | 33 |
| ELECTRODE<br>69.8μm<br>UBM<br>□Luμm<br>66.8μm | □40 | 39 |
| | □50 | 34 |
| | □60 | 30 |

[FIG. 8]

EP 2 629 323 A1

[FIG. 9]

[FIG. 10]

| CHIP | | AVERAGE BUMP HEIGHT [μm] | STANDARD DEVIATION [μm] | MAXIMUM HEIGHT [μm] | MINIMUM HEIGHT [μm] | VARIATION (STANDARD DEVIATION/ AVERAGE BUMP HEIGHT) |
|---|---|---|---|---|---|---|
| SCREEN PRINTING METHOD | No.1 | 15.72 | 1.71 | 21.61 | 5.34 | 0.11 |
| | No.2 | 16.93 | 1.79 | 21.75 | 13.26 | 0.11 |
| | No.3 | 15.59 | 1.57 | 21.46 | 11.51 | 0.1 |
| BALL MOUNTING METHOD | UBMφ40 | 40.22 | 3.33 | 46.43 | 27.39 | 0.08 |
| | UBMφ50 | 36.65 | 3.11 | 42.49 | 26.56 | 0.08 |
| | UBMφ60 | 33.60 | 1.28 | 36.68 | 30.76 | 0.04 |

[FIG. 11]

D

104 — ~ 104
102 — ~ 102

Lh Lh

ELECTRODE PITCH ≦ OPENING LENGTHK Lh (≒ ELECTRODE SIZE) ×2

[FIG. 12]

## INTERNATIONAL SEARCH REPORT

| | International application No. |
|---|---|
| | PCT/JP2011/071598 |

### A. CLASSIFICATION OF SUBJECT MATTER
*H01L21/60*(2006.01)i

According to International Patent Classification (IPC) or to both national classification and IPC

### B. FIELDS SEARCHED

Minimum documentation searched (classification system followed by classification symbols)
H01L21/60

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2008-311530 A (Rohm Co., Ltd.),<br>25 December 2008 (25.12.2008),<br>paragraphs [0008] to [0045]; fig. 1, 13, 15<br>& US 2010/0187685 A1 & WO 2008/153128 A1<br>& CN 101681859 A | 1-2,9<br>3-8 |
| Y | JP 2006-351767 A (Sanyo Electric Co., Ltd.),<br>28 December 2006 (28.12.2006),<br>paragraphs [0010], [0027]<br>& US 2007/0001302 A1 & EP 1734579 A2<br>& KR 10-2006-0131647 A & CN 1881572 A<br>& SG 128598 A | 3-8 |
| Y | JP 2006-120803 A (Fujitsu Ltd.),<br>11 May 2006 (11.05.2006),<br>paragraphs [0040] to [0041]<br>(Family: none) | 3-8 |

☐ Further documents are listed in the continuation of Box C.    ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 30 November, 2011 (30.11.11) | 13 December, 2011 (13.12.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003152007 A